# EUROPEAN PATENT APPLICATION

(11) **EP 4 650 758 A1**
(43) Date of publication of application: **19.11.2025**
(21) Application number: 25176341.3
(22) Date of filing: 14.05.2025
(51) Int. Cl.: G01N 23/04, H01J 37/26, H01J 37/28, G01N 23/205, G01N 23/2055, H01J 37/09, H01J 37/20

(54) **IMAGE ACQUISITION METHOD AND SCANNING TRANSMISSION ELECTRON MICROSCOPE**

(30) Priority: 16.05.2024 JP 2024080469
(71) Applicant: JEOL Ltd., Akishima-shi, Tokyo 196-8558 (JP)
(72) Inventor: KOIBUCHI, Wataru, Tokyo, 196-8558 (JP); SAGAWA, Ryusuke, Tokyo, 196-8558 (JP)
(74) Representative: Boult Wade Tennant LLP

(57) **Abstract**

An image acquisition method of acquiring an image of a crystalline specimen in a scanning transmission electron microscope (100) that includes: an electron source (11) configured to emit an electron beam; an illumination system (2) including a condenser lens (12), an aperture, an illumination system deflector (14) configured to deflect the electron beam having passed through the aperture, and an objective lens (16); a specimen stage (20) configured to support the specimen; an imaging apparatus (30) capable of photographing a Ronchigram formed on a diffraction plane of the objective lens (16); and an imaging system deflector (18) configured to deflect the electron beam to be incident on the imaging apparatus (30), includes the steps of: aligning a center of the Ronchigram with a center of a detector plane (32) of the imaging apparatus (30); aligning a direction of incidence of the electron beam with respect to the specimen with a crystal zone axis of the specimen by aligning a shadow of the aperture with the crystal zone axis on the diffraction plane; and causing the imaging system deflector (18) to deflect the electron beam to align the electron beam with the center of the detector plane (32) of the imaging apparatus (30).

## Description

### BACKGROUND OF THE INVENTION

### Field of the Invention

The present invention relates to an image acquisition method and a scanning transmission electron microscope.

### Description of Related Art

A scanning transmission electron microscope (STEM) is an apparatus for scanning a specimen with a focused electron beam and detecting electrons having been transmitted through the specimen to obtain a scanning transmission electron microscope image (STEM image).

In a scanning transmission electron microscope, when observing a specimen with crystallinity, a direction of incidence of an electron beam is aligned with a crystal zone axis, as disclosed in JP 2024-39605 A. In a crystal, a group of planes parallel to a certain direction is called a crystal zone and a direction thereof is called a crystal zone axis.

When aligning the direction of incidence of an electron beam with a crystal zone axis, the crystal zone axis is aligned with the direction of incidence of the electron beam by tilting a specimen using a specimen stage. However, tilting the specimen on the specimen stage causes a drift in the specimen due to backlash and other effects.

### SUMMARY OF THE INVENTION

According to a first aspect of the present disclosure, there is provided an image acquisition method of acquiring an image of a crystalline specimen in a scanning transmission electron microscope that includes:
an electron source that emits an electron beam;
an illumination system including a condenser lens, an aperture, and an illumination system deflector that deflects the electron beam having passed through the aperture;
a specimen stage that supports a specimen;
an imaging apparatus capable of photographing a Ronchigram formed on a diffraction plane; and
an imaging system deflector that deflects the electron beam to be incident on the imaging apparatus,
the image acquisition method including steps of:
   aligning a center of the Ronchigram with a center of a detector plane of the imaging apparatus;
   aligning a direction of incidence of the electron beam with respect to the specimen with a crystal zone axis of the specimen by aligning a shadow of the aperture with the crystal zone axis on the diffraction plane; and
   causing the imaging system deflector to deflect the electron beam to align the electron beam with the center of the detector plane of the imaging apparatus.

According to a second aspect of the present disclosure, there is provided a scanning transmission electron microscope including:
an electron source that emits an electron beam;
an illumination system including a condenser lens, an aperture, and an illumination system deflector that deflects the electron beam having passed through the aperture;
a specimen stage that supports a specimen;
an imaging apparatus capable of photographing a Ronchigram formed on a diffraction plane;
an imaging system deflector that deflects the electron beam to be incident on the imaging apparatus; and
a control unit that controls the illumination system and the imaging system deflector,
the control unit performing processing of:
   causing the imaging system deflector to deflect the electron beam to align a center of the Ronchigram with a center of a detector plane of the imaging apparatus;
   aligning a direction of incidence of the electron beam with respect to the specimen with a crystal zone axis of the specimen by aligning a shadow of the aperture with the crystal zone axis on the diffraction plane; and
   causing the imaging system deflector to deflect the electron beam to align the electron beam with the center of the detector plane of the imaging apparatus.

According to a third aspect of the present disclosure, there is provided a scanning transmission electron microscope including:
an electron source that emits an electron beam;
an illumination system for scanning a specimen with the electron beam;
a specimen stage that supports the specimen;
a detector that detects electrons having passed through the specimen; and
a control unit that controls the illumination system,
the control unit performing processing of scanning the specimen with the electron beam to acquire a scanned image, and
in the processing of acquiring the scanned image, the control unit makes a direction in which scan lines are drawn orthogonal to a direction of a tilt of the specimen.

### BRIEF DESCRIPTION OF THE DRAWINGS

FIG. 1 is a diagram illustrating an example of a configuration of a scanning transmission electron microscope.
FIG. 2 is a flow chart illustrating an example of an image acquisition method of a scanning transmission electron microscope image.
FIG. 3 is an image of a Ronchigram photographed by an imaging apparatus.
FIG. 4 is an image of a Ronchigram in a state in which a condenser aperture is inserted on an optical axis of an optical system;
FIG. 5 is a diagram schematically illustrating a scanning transmission electron microscope when a condenser aperture is inserted in a state where a center of a Ronchigram is aligned with a center of a detector plane.
FIG. 6 is an image of a Ronchigram in a state in which a shadow of a condenser aperture is aligned with a crystal zone axis on a diffraction plane.
FIG. 7 is a diagram schematically illustrating a scanning transmission electron microscope when a condenser aperture is aligned with a crystal zone axis.
FIG. 8 is an image of a Ronchigram in a state in which a shadow of a condenser aperture is positioned outside of a circle A on a diffraction plane.
FIG. 9 is an image of a Ronchigram when an electron beam is swung back by an imaging system deflector.
FIG. 10 is a diagram schematically illustrating a scanning transmission electron microscope when an electron beam is swung back.
FIG. 11 is a diagram schematically illustrating a situation in which a specimen tilted with respect to an optical axis is scanned by an electron beam;
FIG. 12 is a diagram schematically illustrating a situation in which a specimen tilted with respect to an optical axis is scanned by an electron beam.
FIG. 13 is a diagram schematically illustrating a situation in which a specimen tilted with respect to an optical axis is scanned by an electron probe while keeping focus constant.
FIG. 14 is a diagram schematically illustrating a situation in which a specimen tilted with respect to an optical axis is scanned by an electron probe by varying the focus.
FIG. 15 is illustrates an example of an image of change in a Ronchigram.
FIG. 16 illustrates an example of a method of determining a center of a Ronchigram.
FIG. 17 is a flow chart illustrating an example of image acquisition processing by a control unit.
FIG. 18 illustrates a relationship between a tilt of a specimen and chromatic aberration.

### DESCRIPTION OF THE INVENTION

According to an embodiment aspect of the present disclosure, there is provided an image acquisition method of acquiring an image of a crystalline specimen in a scanning transmission electron microscope that includes:
an electron source that emits an electron beam;
an illumination system including a condenser lens, an aperture, and an illumination system deflector that deflects the electron beam having passed through the aperture;
a specimen stage that supports a specimen;
an imaging apparatus capable of photographing a Ronchigram formed on a diffraction plane; and
an imaging system deflector that deflects the electron beam to be incident on the imaging apparatus,
the image acquisition method including steps of:
   aligning a center of the Ronchigram with a center of a detector plane of the imaging apparatus;
   aligning a direction of incidence of the electron beam with respect to the specimen with a crystal zone axis of the specimen by aligning a shadow of the aperture with the crystal zone axis on the diffraction plane; and
   causing the imaging system deflector to deflect the electron beam to align the electron beam with the center of the detector plane of the imaging apparatus.

In such an image acquisition method, a direction of incidence of an electron beam with respect to a specimen can be aligned with a crystal zone axis by moving a shadow of an aperture on a diffraction plane to align the shadow with the crystal zone axis. Therefore, with such an image acquisition method, a drift of the specimen caused by tilting the specimen stage can be reduced.

According to an embodiment of the present disclosure, there is provided a scanning transmission electron microscope including:
an electron source that emits an electron beam;
an illumination system including a condenser lens, an aperture, and an illumination system deflector that deflects the electron beam having passed through the aperture;
a specimen stage that supports a specimen;
an imaging apparatus capable of photographing a Ronchigram formed on a diffraction plane;
an imaging system deflector that deflects the electron beam to be incident on the imaging apparatus; and
a control unit that controls the illumination system and the imaging system deflector,
the control unit performing processing of:
   causing the imaging system deflector to deflect the electron beam to align a center of the Ronchigram with a center of a detector plane of the imaging apparatus;
   aligning a direction of incidence of the electron beam with respect to the specimen with a crystal zone axis of the specimen by aligning a shadow of the aperture with the crystal zone axis on the diffraction plane; and
   causing the imaging system deflector to deflect the electron beam to align the electron beam with the center of the detector plane of the imaging apparatus.

In such a scanning transmission electron microscope, a direction of incidence of an electron beam with respect to a specimen can be aligned with a crystal zone axis by moving a shadow of an aperture on a diffraction plane to align the shadow with the crystal zone axis. Therefore, with such a scanning transmission electron microscope, a drift of the specimen caused by tilting the specimen stage can be reduced.

According to an embodiment aspect of the present disclosure, there is provided a scanning transmission electron microscope including:
an electron source that emits an electron beam;
an illumination system for scanning a specimen with the electron beam;
a specimen stage that supports the specimen;
a detector that detects electrons having passed through the specimen; and
a control unit that controls the illumination system,
the control unit performing processing of scanning the specimen with the electron beam to acquire a scanned image, and
in the processing of acquiring the scanned image, the control unit makes a direction in which scan lines are drawn orthogonal to a direction of a tilt of the specimen.

With such a scanning transmission electron microscope, even when the specimen is tilted, a change in a height of the specimen while drawing one scan line can be reduced.

Now preferred embodiments of the invention will be described in detail with reference to the drawings. The embodiments described below are not intended to unduly limit the contents of the invention described in the claims. Further, all of the components described below are not necessarily essential requirements of the invention.

### 1. Scanning Transmission Electron Microscope

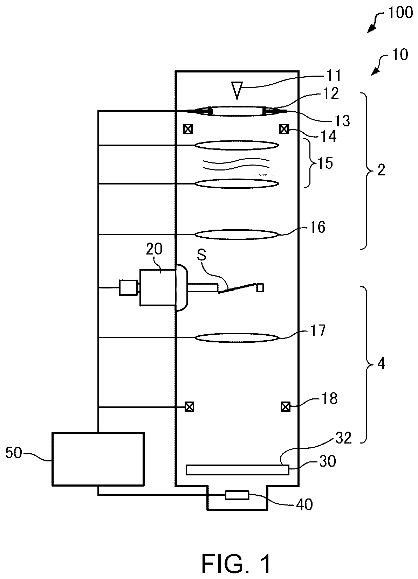

First, a scanning transmission electron microscope according to an embodiment of the invention will be described with reference to the drawings. FIG. 1 is a diagram illustrating an example of a configuration of a scanning transmission electron microscope 100 according to the present embodiment.

The scanning transmission electron microscope 100 is an apparatus for scanning a specimen S with an electron beam (electron probe) and detecting electrons having been transmitted through the specimen S to obtain a scanned image (a scanning transmission electron microscope image, hereinafter also referred to as a "STEM image").

As illustrated in FIG. 1, the scanning transmission electron microscope 100 includes an optical system 10, a specimen stage 20, an imaging apparatus 30, a detector 40, and a control unit 50.

The optical system 10 includes an electron source 11, a condenser lens 12, a condenser aperture 13 (an example of an aperture), an illumination system deflector 14, an aberration corrector 15, an objective lens 16, an intermediate lens 17, and an imaging system deflector 18.

The electron source 11 emits an electron beam. The electron source 11 is, for example, an electron gun which accelerates electrons emitted from a cathode by an anode and which emits an electron beam. An accelerating voltage is applied between the cathode and the anode.

The condenser lens 12 focuses the electron beam emitted from the electron source 11. Although not illustrated, the condenser lens 12 may be constituted by a plurality of electron lenses.

The condenser aperture 13 is disposed inside of the condenser lens 12. The condenser aperture 13 is an aperture for determining a convergence angle of an electron beam or a dose of the beam.

The illumination system deflector 14 deflects an electron beam that the specimen S is illuminated with and tilts the electron beam with respect to the optical axis of an illumination system 2. The illumination system deflector 14 may be built into the aberration corrector 15. For example, the illumination system deflector 14 is disposed between the condenser lens 12 and the aberration corrector 15. Note that a position of the illumination system deflector 14 is not particularly limited as long as the illumination system deflector 14 is built into the illumination system 2.

The aberration corrector 15 corrects an aberration of the illumination system 2. The aberration corrector 15 is disposed between the condenser lens 12 and the objective lens 16. The aberration corrector 15 is, for example, a spherical aberration corrector that corrects a spherical aberration of the illumination system 2.

The illumination system 2 is an optical system that is disposed before the specimen S in order to illuminate the specimen S with an electron beam. In the scanning transmission electron microscope 100, the condenser lens 12, the condenser aperture 13, the aberration corrector 15, and the objective lens 16 (an upstream-side magnetic field of the objective lens 16) constitute the illumination system 2. The illumination system 2 causes an electron beam to converge to form an electron probe. The electron probe is a focal point where an electron beam is most focused. Although not illustrated, the illumination system 2 includes a scanning coil for deflecting the electron beam and scanning the specimen S with the electron probe.

The objective lens 16 focuses an electron beam to form an electron probe. An electron diffraction pattern, a Kikuchi pattern, a Ronchigram, and the like are formed on a back focal plane or, in other words, a diffraction plane of the objective lens 16. A Ronchigram is a projected image (pattern) of a specimen that is formed on a diffraction plane by focusing an electron beam near the specimen in a scanning transmission electron microscope.

The intermediate lens 17 enlarges and transfers an electron diffraction pattern, a Kikuchi pattern, and a Ronchigram formed on the back focal plane of the objective lens 16. The imaging system deflector 18 is disposed before the imaging apparatus 30. The imaging system deflector 18 is disposed between the intermediate lens 17 and the imaging apparatus 30. The imaging system deflector 18 deflects an electron beam that has passed through the specimen S and is to be incident on the imaging apparatus 30. Note that a position of the imaging system deflector 18 is not particularly limited as long as the imaging system deflector 18 is built into an imaging system 4.

In the scanning transmission electron microscope 100, a downstream-side magnetic field of the objective lens 16, the intermediate lens 17, and the imaging system deflector 18 constitute the imaging system 4. The imaging system 4 is an optical system disposed behind the specimen S in order to capture an image of the specimen S with a transmitted electron beam.

Note that the optical system 10 may include optical elements other than the lenses and apertures described above.

The specimen stage 20 supports the specimen S. The specimen S supported by the specimen stage 20 is disposed between the upstream-side magnetic field of the objective lens 16 and the downstream-side magnetic field of the objective lens 16. The specimen S is positioned by the specimen stage 20. The specimen stage 20 includes a moving mechanism that moves the specimen S in a height direction, a moving mechanism that moves the specimen S in a horizontal direction, and a tilting mechanism that tilts the specimen S. The height direction of the specimen S is a direction along an optical axis of the illumination system 2.

The imaging apparatus 30 is disposed on the back focal plane of the objective lens 16 or a surface conjugate to the back focal plane of the objective lens 16. In the imaging apparatus 30, a Ronchigram, an electron diffraction pattern, a Kikuchi pattern, and the like formed in the diffraction plane can be photographed. For example, the imaging apparatus 30 is a digital camera that is capable of recording a Ronchigram or the like as a two-dimensional digital image.

A center of a detector plane 32 (a center of a sensor) of the imaging apparatus 30 is positioned on the optical axis of the optical system 10. In addition, the center of the detector plane 32 of the imaging apparatus 30 corresponds to a center of an image having been imaged by the imaging apparatus 30.

The detector 40 detects electrons having passed through the specimen S. The detector 40 is a detector for acquiring a STEM image. The detector 40 is disposed on the optical axis of the optical system 10. Note that although not illustrated, the scanning transmission electron microscope 100 may include, as a detector for detecting electrons that are transmitted through the specimen S, an annular detector for acquiring a high-angle annular dark-field image (HAADF-STEM image).

The control unit 50 (a computer) controls each unit that constitutes the scanning transmission electron microscope 100. The control unit 50 controls the optical system 10 and the specimen stage 20. For example, the control unit 50 includes a processor such as a CPU (Central Processing Unit) and a storage apparatus such as a RAM (Random Access Memory) and a ROM (Read Only Memory). The storage apparatus stores programs for performing various kinds of control as well as data. Functions of the control unit 50 can be realized by having the processor execute the programs.

### 2. Image Acquisition Method

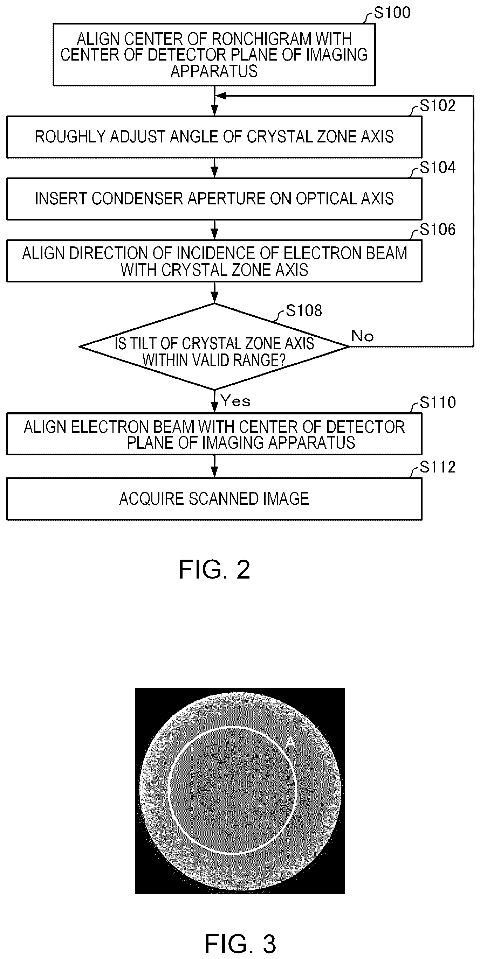

Next, an image acquisition method of a scanning transmission electron microscope image will be described. Here, a case of acquiring a high-resolution STEM image of a crystalline specimen will be described. FIG. 2 is a flow chart illustrating an example of an acquisition method of a STEM image.

First, a center of a Ronchigram is aligned with a center of the detector plane 32 of the imaging apparatus 30 (step S100).

FIG. 3 is an image of a Ronchigram photographed by the imaging apparatus 30. A circle A illustrated in FIG. 3 represents an area in which intensity of the Ronchigram is uniform. A center of the Ronchigram is a center of the area in which the intensity of the Ronchigram is uniform and coincides with a center of the circle A. In this manner, the center of a Ronchigram can be confirmed based on an image of the Ronchigram photographed by the imaging apparatus 30. In addition, as will be described in "3. Method of Determining Center of Ronchigram" later, the center of the Ronchigram may be determined based on an image of a change in the Ronchigram due to a change in a relative positional relationship between the specimen and the electron probe. The center of the Ronchigram can be aligned with a center of the detector plane 32 of the imaging apparatus 30 by causing the imaging system deflector 18 to deflect an electron beam.

Next, an angle of a crystal zone axis of the specimen S is roughly adjusted (step S102). Specifically, first, the specimen S is moved to a desired photography area with the specimen stage 20. Next, the specimen S is tilted with the specimen stage 20 so that a tilt of the crystal zone axis with respect to the optical axis of the illumination system 2 decreases. For example, the tilt of the crystal zone axis with respect to the optical axis is reduced by tilting the specimen S with the specimen stage 20 while checking the crystal zone axis using a Kikuchi pattern or an electron diffraction pattern photographed by the imaging apparatus 30 so that the crystal zone axis approaches the center of the image. The crystal zone axis can be roughly adjusted according to the step described above.

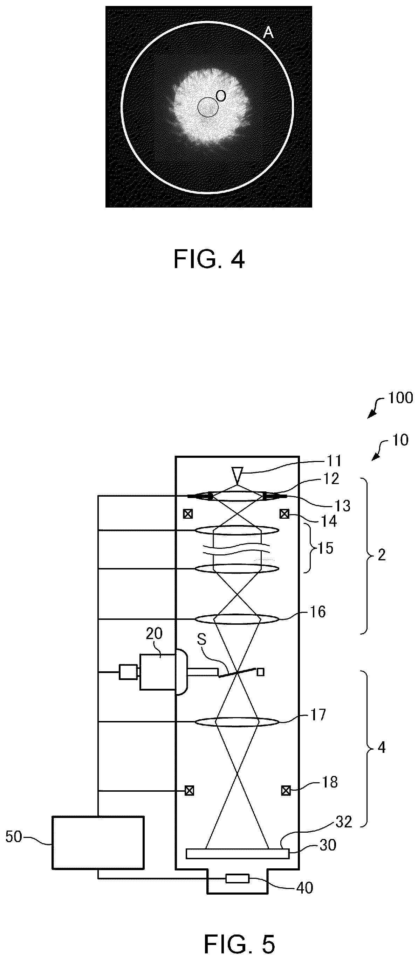

Next, the condenser aperture 13 is inserted on the optical axis of the illumination system 2 (step S104). FIG. 4 is an image of a Ronchigram in a state in which the condenser aperture 13 is inserted on the optical axis of the illumination system 2. FIG. 4 illustrates a center O of the detector plane 32 of the imaging apparatus 30. Inserting the condenser aperture 13 enables a shadow of the condenser aperture 13 to be confirmed on the diffraction plane as illustrated in FIG. 4.

Note that step S104 of introducing the condenser aperture 13 may be performed before step S102 or performed after step S106.

FIG. 5 is a diagram schematically illustrating the scanning transmission electron microscope 100 when the condenser aperture 13 is inserted in a state where a center of a Ronchigram is aligned with the center O of the detector plane 32. In the state illustrated in FIG. 5, the specimen S is tilted with respect to the optical axis and an electron beam is incident on the specimen S along the optical axis. Therefore, the direction of incidence of the electron beam is not aligned with the crystal zone axis.

Next, the direction of incidence of the electron beam is aligned with the crystal zone axis by aligning a shadow of the condenser aperture 13 on the diffraction plane with the crystal zone axis (step S106). As illustrated in FIG. 4, a Kikuchi pattern appearing on the diffraction plane shows that the direction of incidence of the electron beam deviates from the crystal zone axis. The position of the crystal zone axis can be confirmed based on the Kikuchi pattern appearing on the diffraction plane. Therefore, the electron beam is tilted with the illumination system deflector 14 while checking the shadow of the condenser aperture 13 on an image photographed by the imaging apparatus 30 so that a center of a circle created by the shadow of the condenser aperture 13 and the crystal zone axis coincide with each other. Accordingly, the shadow of the condenser aperture 13 can be aligned with the crystal zone axis on the diffraction plane.

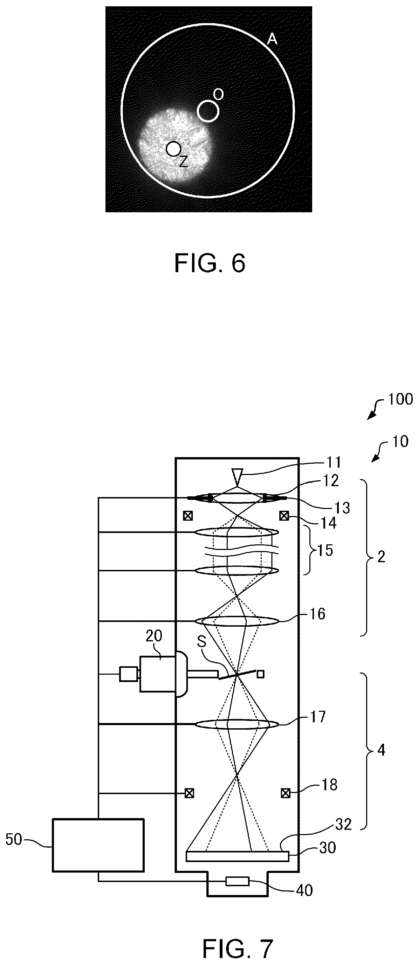

FIG. 6 is an image of a Ronchigram in a state in which the shadow of the condenser aperture 13 is aligned with a crystal zone axis Z on a diffraction plane. FIG. 7 is a diagram schematically illustrating the scanning transmission electron microscope 100 when the shadow of the condenser aperture 13 is aligned with the crystal zone axis Z by tilting an electron beam with the illumination system deflector 14.

As illustrated in FIG. 7, the shadow of the condenser aperture 13 moves on the diffraction plane by tilting an electron beam with the illumination system deflector 14, and as illustrated in FIG. 6, the shadow of the condenser aperture 13 can be aligned with the crystal zone axis Z on the diffraction plane. Accordingly, the direction of incidence of the electron beam with respect to the specimen S can be aligned with the crystal zone axis Z.

Note that while the shadow of the condenser aperture 13 is aligned with the crystal zone axis Z by tilting an electron beam with the illumination system deflector 14 in this case, the shadow of the condenser aperture 13 may be aligned with the crystal zone axis Z by moving the condenser aperture 13 in a mechanical manner.

Next, a determination is made as to whether or not the tilt of the crystal zone axis with respect to the optical axis of the illumination system 2 is within a valid range (step S108).

In this case, a circle A in FIG. 6 represents an area in which intensity of the Ronchigram is uniform. The area in which intensity of the Ronchigram is uniform is an angular range where there is no aberration. Therefore, disposing the shadow of the condenser aperture 13 in the circle A enables an electron beam in an angular range with no aberration to be selected with the condenser aperture 13. Accordingly, the specimen S can be illuminated with an electron beam in an angular range with no aberration.

For example, if the tilt of the crystal zone axis with respect to the optical axis is large, the shadow of the condenser aperture 13 may be positioned outside of the circle A when the shadow of the condenser aperture 13 is aligned with the crystal zone axis Z.

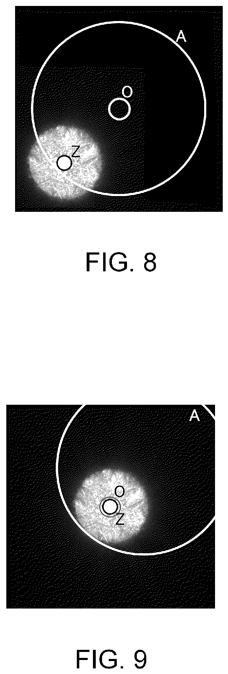

FIG. 8 is an image of a Ronchigram in a state in which the shadow of the condenser aperture 13 is positioned outside of the circle A on the diffraction plane. As illustrated in FIG. 8, when the shadow of the condenser aperture 13 is positioned outside of the circle A, an electron beam in an angular range with no aberration cannot be selected with the condenser aperture 13.

Therefore, in step S108, whether or not a magnitude of the tilt of the crystal zone axis is within a valid range is determined. Specifically, whether or not the magnitude of the tilt of the crystal zone axis is within the valid range is determined based on whether or not the shadow of the condenser aperture 13 is positioned in the circle A when the shadow of the condenser aperture 13 is aligned with the crystal zone axis. Here, a case where the shadow of the condenser aperture 13 is positioned in the circle A refers to a case where a circle created by the shadow of the condenser aperture 13 is entirely included in the circle A.

Note that a diameter of the circle A may be obtained in advance by studying an area with uniform intensity in the Ronchigram photographed by the imaging apparatus 30. Alternatively, the diameter of the circle A may be calculated based on performance of the optical system 10 including the aberration corrector 15.

When the tilt of the crystal zone axis is outside of the valid range (No in step S108) or, in other words, when the shadow of the condenser aperture 13 is not positioned in the circle A as illustrated in FIG. 8, a return is made to step S102 to tilt the specimen S with the specimen stage 20 and roughly adjust the angle of the crystal zone axis. Subsequently, step S104, step S106, and step S108 are performed.

When the tilt of the crystal zone axis is within the valid range (Yes in step S108) or, in other words, when the shadow of the condenser aperture 13 is positioned in the circle A as illustrated in FIG. 6, the electron beam is deflected by the imaging system deflector 18 and aligned with the center O of the detector plane 32 of the imaging apparatus 30 (step S110).

In the state illustrated in FIG. 6, since the electron beam deviates from the optical axis of the optical system 10, the electron beam cannot be detected by the detector 40. Therefore, the electron beam is swung back by the imaging system deflector 18 to move the shadow of the condenser aperture 13 to the center O of the detector plane 32 and cause the electron beam to be incident on the center O of the detector plane 32.

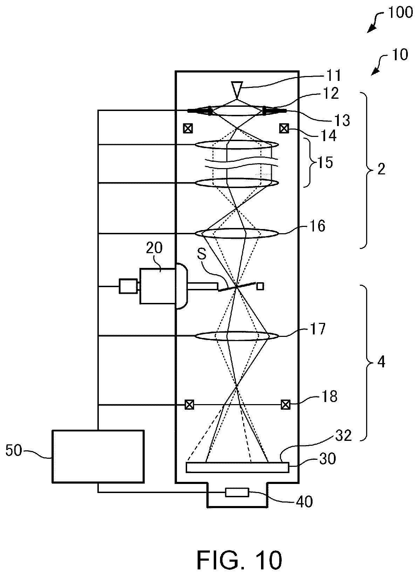

FIG. 9 is an image of a Ronchigram when the electron beam is swung back by the imaging system deflector 18. FIG. 10 is a diagram schematically illustrating the scanning transmission electron microscope 100 when the electron beam is swung back by the imaging system deflector 18.

By swinging back the electron beam by the imaging system deflector 18 as illustrated in FIG. 10, the shadow of the condenser aperture 13 and the crystal zone axis Z can be moved to the center O of the detector plane 32 of the imaging apparatus 30 as illustrated in FIG. 9.

The direction of incidence of the electron beam with respect to the specimen S can be aligned with the crystal zone axis according to the steps described above.

Next, the specimen S is scanned with the electron beam to acquire a scanned image (STEM image) (step S112).

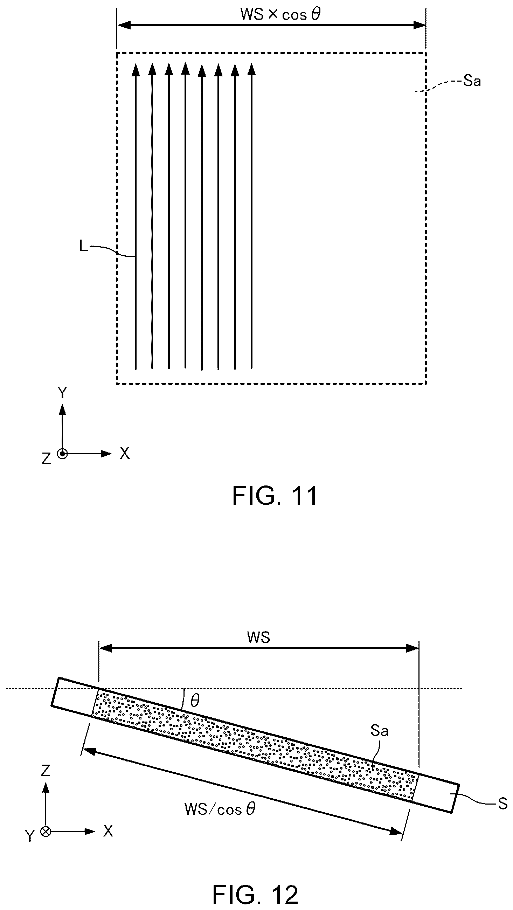

FIGS. 11 and 12 are diagrams schematically illustrating a situation in which the specimen S that is tilted with respect to the optical axis of the illumination system 2 is scanned by an electron probe. FIG. 11 is a plan view schematically illustrating a scan area Sa of the specimen S. FIG. 12 is a sectional view schematically illustrating the specimen S. Note that FIGS. 11 and 12 illustrate an X axis, a Y axis, and a Z axis that are orthogonal to each other. The Z axis is parallel to the optical axis of the illumination system 2.

In the scanning transmission electron microscope 100, a STEM image of the scan area Sa is acquired by raster scanning in which the electron probe draws a plurality of scan lines L in the scan area Sa. In this case, a direction in which the scan lines L are drawn is made orthogonal to a direction of tilt of the specimen S. In the example in FIGS. 11 and 12, the specimen S is tilted in the X direction. Therefore, the scan lines L are drawn in the Y direction. Accordingly, a change in a height of the specimen S while drawing one scan line L can be reduced. Therefore, focus can be kept constant while drawing one scan line L. In other words, a position of the electron probe in the Z direction that is a convergence point of the electron beam can be kept constant. For example, when the direction in which the scan line L is drawn is not orthogonal to the direction of the tilt of the specimen S, the height of the specimen S changes and the focus deviates while drawing one scan line L and the STEM image becomes blurry.

A magnification of a STEM image is expressed as WD/WS, where WS denotes a width of the scan area Sa and WD denotes a display width of the STEM image. Therefore, as illustrated in FIG. 12, when the specimen S is tilted with respect to the optical axis by an angle θ in the X direction, the magnification of the STEM image in the X direction is multiplied by cosθ. In other words, the STEM image is reduced in the X direction. Therefore, as illustrated in FIG. 11, the width WS of the scan area Sa in the X direction is multiplied by cosθ to make the width of the scan area Sa WS × cosθ. Accordingly, the STEM image can be prevented from being reduced in the direction of the tilt of the specimen S.

Note that the reduction in the X direction of the acquired STEM image can be corrected by image processing, using the width of the scan area Sa as WS. In other words, the X direction of the STEM image may be multiplied by 1/cosθ.

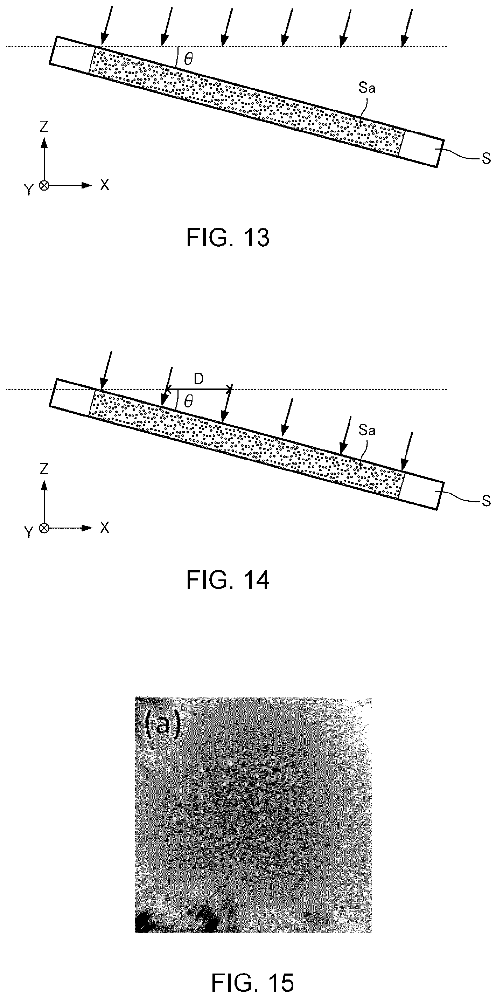

FIG. 13 is a diagram schematically illustrating a situation in which the specimen S tilted with respect to the optical axis of the illumination system 2 is scanned by an electron probe while keeping focus constant. FIG. 14 is a diagram schematically illustrating a situation in which the specimen S tilted with respect to the optical axis of the illumination system 2 is scanned by an electron probe by varying the focus according to the magnitude of the tilt of the specimen S.

As illustrated in FIG. 13, when the focus is made constant, a shift in focus occurs between an end in the +X direction and an end in the -X direction of the scan area Sa. Therefore, as illustrated in FIG. 14, the focus is changed by an amount corresponding to the magnitude (angle θ) of the tilt of the specimen S every time the scan line L is drawn. Specifically, when an interval at which the scan lines L are drawn is denoted by D, the focus is changed by D × tanθ every time the scan line L is drawn. Accordingly, a shift in focus due to the tilt of the specimen S can be reduced.

The focus can be changed by changing an acceleration voltage, excitation of the objective lens 16, or the height of the specimen S. Note that response speed can be increased by controlling the acceleration voltage to control the focus. For example, since the objective lens 16 changes focus by changing an excitation current supplied to a coil, response speed is low. In addition, since the height of the specimen S is changed by mechanically operating the specimen stage 20, response speed is low. In contrast, since the acceleration voltage is the voltage applied to the cathode and the anode of the electron source 11, response speed is high.

As described above, information on the direction of the tilt of the specimen S and the magnitude (angle θ) of the tilt of the specimen S is required in order to acquire a STEM image. Therefore, the information on the direction of the tilt of the specimen S and the magnitude (angle θ) of the tilt of the specimen S is calculated based on a direction of deflection and an amount of deflection of the electron beam by the illumination system deflector 14 when the shadow of the condenser aperture 13 is aligned with the crystal zone axis.

For example, calibration data indicating a relationship between a control amount of the illumination system deflector 14 (for example, an excitation current) and the direction of deflection and the amount of deflection of the electron beam is acquired in advance. Using the calibration data, the direction of the tilt of the specimen S and the magnitude of the tilt of the specimen S are calculated based on the control amount of the illumination system deflector 14 when the condenser aperture 13 is aligned with the crystal zone axis.

Note that the direction of the tilt of the specimen S and the magnitude (angle θ) of the tilt of the specimen S may be calculated based on a distance between the center of the Ronchigram and the crystal zone axis on an image of the diffraction plane photographed by the imaging apparatus 30.

### 3. Method of Determining Center of Ronchigram

Next, a method of determining the center of a Ronchigram will be described.

The center of the Ronchigram can be determined based on an image of a change in the Ronchigram having been photographed by the imaging apparatus 30 while changing excitation of the objective lens 16. The image of a change in the Ronchigram can be acquired by, for example, maintaining the imaging apparatus 30 in an exposed state while changing the excitation of the objective lens 16. The image of a change in the Ronchigram is a recording of a situation of a change in the Ronchigram caused by a change in the excitation (a change in a defocus amount) of the objective lens 16 in a single image.

FIG. 15 illustrates an example of an image of change in the Ronchigram. A pattern of radial straight lines in an image illustrated in FIG. 15 is observed with the center of magnification change or, in other words, the center of the Ronchigram as a center of the pattern. Therefore, ideally, a point where the plurality of straight lines intersect each other coincides with the center of the Ronchigram.

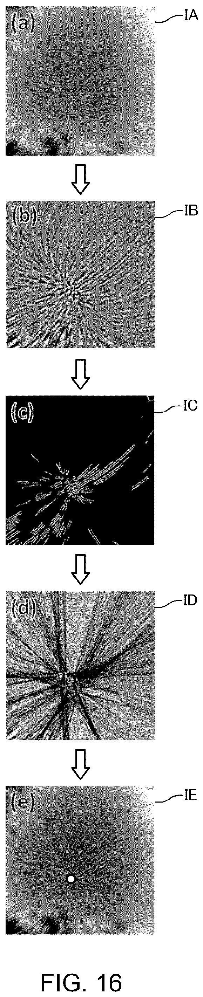

FIG. 16 illustrates an example of a method of determining a center of a Ronchigram from an image of a change in the Ronchigram.

When obtaining the center of a Ronchigram from an image of a change in the Ronchigram, first, a bandpass filter is applied to an image IA of the change in the Ronchigram to remove a noise component (refer to image IB). Next, an edge portion of the image is extracted from an image IB of the change in the Ronchigram from which the noise component has been removed (refer to image IC). Next, a straight component is detected from the image IC of the change in the Ronchigram from which the edge portion has been extracted (image ID). Next, a pair of straight components that intersect each other among the detected straight components are extracted in plurality in the image ID from which the straight components have been detected and an intersection made by each pair is obtained. Next, as illustrated in an image IE, a center of gravity of the plurality of obtained intersections is calculated and a position of the center of gravity is adopted as a position of the center of the Ronchigram. In this manner, obtaining a plurality of intersections and adopting a position of the center of gravity of the intersections as the position of the center of the Ronchigram enables the position of the center of the Ronchigram to be determined with accuracy.

Alternatively, an image of a change in a Ronchigram may be acquired from a plurality of images of the Ronchigram acquired under different conditions with respect to the relative positional relationship between the specimen and the electron probe. In other words, an image of a change in a Ronchigram may be acquired by integrating or averaging a plurality of Ronchigram images acquired under different conditions with respect to an excitation amount of the objective lens 16 and generating a single image.

In addition, while an image of a change in a Ronchigram is acquired by changing excitation of the objective lens 16 in the description provided above, an accelerating voltage may be changed or a height of the specimen S may be changed instead of the excitation of the objective lens 16.

### 4. Processing

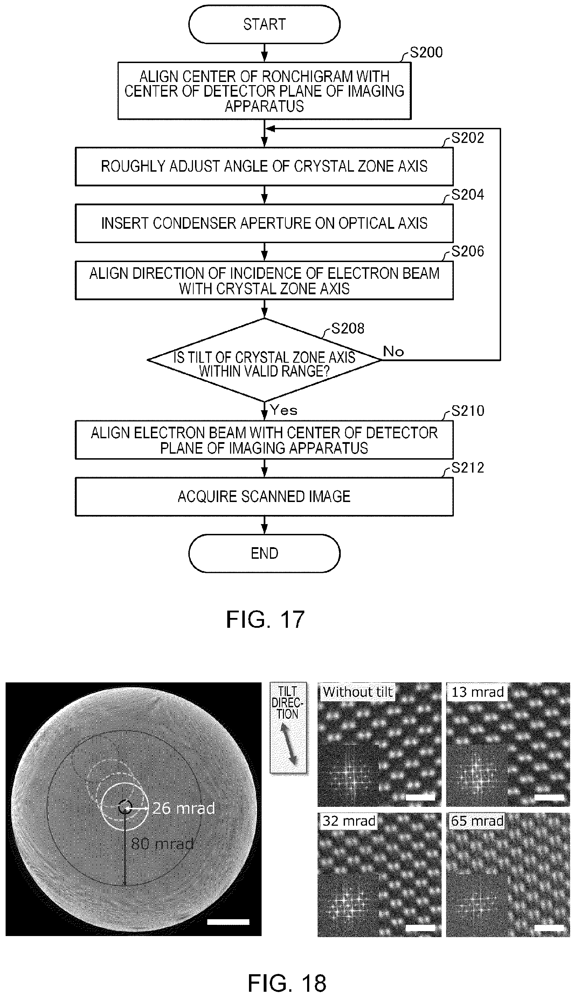

FIG. 17 is a flow chart illustrating an example of image acquisition processing by the control unit 50.

The control unit 50 aligns a center of a Ronchigram with the center O of the detector plane 32 of the imaging apparatus 30 (step S200). The control unit 50 acquires an image of a change in the Ronchigram and determines the center of the Ronchigram based on the image of the change in the Ronchigram. The control unit 50 controls the imaging system deflector 18 so that the center of the Ronchigram coincides with the center O of the detector plane 32.

Next, the control unit 50 roughly adjusts an angle of a crystal zone axis (step S202). The control unit 50 specifies a position of the crystal zone axis on the diffraction plane from a Kikuchi pattern or an electron diffraction pattern photographed by the imaging apparatus 30 and tilts the specimen S by operating the specimen stage 20 so that a tilt of the crystal zone axis with respect to the optical axis decreases.

Next, the control unit 50 inserts the condenser aperture 13 on the optical axis (step S204). Next, the control unit 50 aligns a shadow of the condenser aperture 13 on the diffraction plane with the crystal zone axis to align a direction of incidence of the electron beam with the crystal zone axis (step S206). The control unit 50 operates the illumination system deflector 14 so that a center of a circle created by the shadow of the condenser aperture 13 coincides with the crystal zone axis on an image of the diffraction plane photographed by the imaging apparatus 30. The control unit 50 calculates the position of the crystal zone axis from an image of the Kikuchi pattern. Alternatively, the position of the crystal zone axis may be designated by a user. A direction of incidence of an electron beam with respect to the specimen S can be aligned with the crystal zone axis according to the processing of step S206.

Note that the control unit 50 may align the shadow of the condenser aperture 13 with the crystal zone axis on the diffraction plane by mechanically moving the condenser aperture 13.

Next, the control unit 50 determines whether or not the tilt of the crystal zone axis is within a valid range (step S208). The control unit 50 photographs an image of the diffraction plane with the imaging apparatus 30 and determines whether or not a circle created by the shadow of the condenser aperture 13 is positioned inside of the circle A representing an area in which the intensity of the Ronchigram is uniform on the photographed image. When the control unit 50 determines that the circle created by the shadow of the condenser aperture 13 is positioned inside of the circle A, the control unit 50 determines that the tilt of the crystal zone axis is within the valid range. Note that the diameter of the circle A is set in advance.

When the control unit 50 determines that the tilt of the crystal zone axis is outside of the valid range (No in step S208), the control unit 50 returns to step S202 to tilt the specimen S with the specimen stage 20 and roughly adjust the angle of the crystal zone axis (step S202). Subsequently, the control unit 50 performs the processing of step S204, the processing of S206, and the processing of step S208.

In this manner, the control unit 50 repeats the processing of step S202, the processing of step S204, the processing of S206, and the processing of step S208 until the tilt of the crystal zone axis is determined to be within the valid range.

When the control unit 50 determines that the tilt of the crystal zone axis is within the valid range (Yes in step S208), the control unit 50 swings back the electron beam with the imaging system deflector 18 so that the electron beam is incident on the center O of the detector plane 32 of the imaging apparatus 30 (step S210). The control unit 50 photographs an image of the diffraction plane with the imaging apparatus 30 and operates the imaging system deflector 18 so that the shadow of the condenser aperture 13 coincides with the center O of the detector plane 32 based on the photographed image. Accordingly, the electron beam can be caused to be incident on the detector 40.

Next, the control unit 50 acquires a STEM image (step S212). The control unit 50 calculates a direction of the tilt and a magnitude of the tilt of the specimen S from the excitation amount of the illumination system deflector 14 in the processing of step S206 of aligning the direction of incidence of the electron beam with the crystal zone axis. In addition, the control unit 50 sets scan conditions based on the direction of the tilt and the magnitude of the tilt of the specimen S. The scan conditions include a direction in which the scan lines L are drawn, a width of the scan area Sa, and an amount of change of focus for each scan line L. Specifically, the direction in which the scan lines L are drawn is set to be orthogonal to the direction of the tilt of the specimen S. In addition, the width of the scan area Sa in the tilt direction of the specimen S is set according to the magnitude of the tilt of the specimen S. Furthermore, the amount of change of focus for each scan line L is set according to the magnitude of the tilt of the specimen S. The control unit 50 controls the optical system 10 and the accelerating voltage based on the scan conditions and acquires a STEM image.

After acquiring the STEM image, the control unit 50 ends the image acquisition processing.

### 5. Effects

The image acquisition method according to the present embodiment is an image acquisition method of a crystalline specimen in the scanning transmission electron microscope 100 including: the electron source 11 that emits an electron beam; the illumination system 2 including the condenser lens 12, the condenser aperture 13, and the illumination system deflector 14 that deflects an electron beam having passed through the condenser aperture 13; the specimen stage 20 that supports the specimen S; the imaging apparatus 30 capable of photographing a Ronchigram formed on a diffraction plane; and an imaging system deflector 18 that deflects an electron beam to be incident on the imaging apparatus 30. In addition, the image acquisition method according to the present embodiment includes the steps of: aligning a center of a Ronchigram with the center O of the detector plane 32 of the imaging apparatus 30; aligning a shadow of the condenser aperture 13 with a crystal zone axis of the specimen S on a diffraction plane to align a direction of incidence of an electron beam with respect to the specimen S with the crystal zone axis; and causing the imaging system deflector 18 to deflect an electron beam to align the electron beam with the center O of the detector plane 32 of the imaging apparatus 30.

As described above, in the image acquisition method according to the present embodiment, moving a shadow of the condenser aperture 13 and aligning the shadow with the crystal zone axis on the diffraction plane enables the direction of incidence of an electron beam with respect to the specimen S to be aligned with the crystal zone axis without having to tilt the specimen S with the specimen stage 20. For example, when aligning the direction of incidence of the electron beam with the crystal zone axis by tilting the specimen S with the specimen stage 20, a drift of the specimen S occurs. In contrast, with the image acquisition method according to the present embodiment, a drift of the specimen caused by tilting the specimen stage 20 can be reduced.

After the step of aligning a direction of incidence of an electron beam with a crystal zone axis, the image acquisition method according to the present embodiment includes the steps of: determining whether or not a magnitude of the tilt of the crystal zone axis with respect to an optical axis of the illumination system 2 is within a predetermined range (valid range); and when the magnitude of the tilt of the crystal zone axis has been determined to be outside the predetermined range, tilting the specimen S with the specimen stage 20 and reducing the tilt of the crystal zone axis with respect to the optical axis of the illumination system 2. Therefore, with the image acquisition method according to the present embodiment, even if the specimen S is tilted with respect to the optical axis, a STEM image can be acquired in a state of reduced aberration (state of no aberration).

In the image acquisition method according to the present embodiment, in the step of determining whether or not a magnitude of the tilt of the crystal zone axis with respect to an optical axis of the illumination system 2 is within a predetermined range, the determination is made according to whether or not a circle created by a shadow of the condenser aperture 13 is within an area in which intensity of a Ronchigram is uniform. Therefore, with the image acquisition method according to the present embodiment, a STEM image can be acquired in a state of reduced aberration (state of no aberration).

In the image acquisition method according to the present embodiment, in the step of aligning a direction of incidence of an electron beam with a crystal zone axis, the condenser aperture 13 is aligned with the crystal zone axis by causing the illumination system deflector 14 to tilt the electron beam. Therefore, with the image acquisition method according to the present embodiment, the direction of incidence of an electron beam with respect to the specimen S can be aligned with the crystal zone axis without having to tilt the specimen S with the specimen stage 20.

In the image acquisition method according to the present embodiment, in the step of aligning a direction of incidence of an electron beam with a crystal zone axis, the condenser aperture 13 is aligned with the crystal zone axis by moving the condenser aperture 13. Therefore, with the image acquisition method according to the present embodiment, the direction of incidence of an electron beam with respect to the specimen S can be aligned with the crystal zone axis without having to tilt the specimen S with the specimen stage 20.

In the image acquisition method according to the present embodiment, in the step of aligning a center of a Ronchigram with the center O of the detector plane 32 of the imaging apparatus 30, an image of a change in the Ronchigram in accordance with a change in a relative positional relationship between the specimen S and the electron probe is acquired and the center of the Ronchigram is determined based on the image of the change in the Ronchigram. As a result, in the image acquisition method according to the present embodiment, the center of the Ronchigram can be determined from an amorphous region included in a general specimen without having to prepare a specimen having a characteristic shape. Therefore, for example, the specimen need not be replaced in order to adjust the optical system and the center of the Ronchigram can be readily detected.

The image acquisition method according to the present embodiment includes a step of scanning the specimen S with an electron beam and acquiring a STEM image, wherein in the step of acquiring a STEM image, a direction in which scan lines L are drawn is made orthogonal to a direction of the tilt of the specimen S. Therefore, in the image acquisition method according to the present embodiment, a change in a height of the specimen S while drawing one scan line L can be reduced.

In the image acquisition method according to the present embodiment, in the step of acquiring a STEM image, focus is changed by an amount corresponding to the tilt of the specimen S every time the scan line L is drawn. Therefore, in the image acquisition method according to the present embodiment, a shift in focus due to the tilt of the specimen S can be reduced.

In the image acquisition method according to the present embodiment, in the step of acquiring a STEM image, a magnitude of the scan area Sa in the direction of the tilt of the specimen S is determined based on the direction of the tilt of the specimen S and a magnitude of the tilt of the specimen S. Therefore, in the image acquisition method according to the present embodiment, the STEM image can be prevented from being reduced in the direction of the tilt of the specimen S.

The image acquisition method according to the present embodiment includes a step of correcting a magnitude of the STEM image in a direction corresponding to the direction of the tilt of the specimen S based on the direction of the tilt of the specimen S and the magnitude of the tilt of the specimen S. Therefore, in the image acquisition method according to the present embodiment, the STEM image having been reduced in the direction of the tilt of the specimen S can be corrected.

The image acquisition method according to the present embodiment includes a step of calculating the direction of the tilt of the specimen S and the magnitude of the tilt of the specimen S based on a deflection direction and a deflection amount of an electron beam by the illumination system deflector 14. Therefore, in the image acquisition method according to the present embodiment, information on the direction of the tilt of the specimen S and the magnitude of the tilt of the specimen S can be readily acquired.

In the scanning transmission electron microscope 100, the control unit 50 performs processing of: causing the imaging system deflector 18 to deflect an electron beam to align a center of a Ronchigram with the center O of the detector plane 32 of the imaging apparatus 30; aligning a shadow of the condenser aperture 13 with a crystal zone axis of the specimen S on a diffraction plane to align a direction of incidence of an electron beam with respect to the specimen S with the crystal zone axis; and causing the imaging system deflector 18 to deflect an electron beam to align the electron beam with the center O of the detector plane 32 of the imaging apparatus 30. Therefore, with the scanning transmission electron microscope 100, a drift of the specimen caused by tilting the specimen stage 20 can be reduced.

### 6. Modifications

In the embodiment described above, in step S108 of determining whether or not the tilt of the crystal zone axis is within a valid range, the determination of whether or not the tilt of the crystal zone axis is within a valid range is made according to whether or not a circle created by a shadow of the condenser aperture 13 is positioned in the circle A representing an area in which intensity of a Ronchigram is uniform.

In contrast, a criterion for determining whether or not the tilt of the crystal zone axis is within the valid range in step S108 is not limited to the above. For example, whether or not the tilt of the crystal zone axis is within a valid range may be determined according to whether or not a circle created by the shadow of the condenser aperture 13 is positioned in a circle representing an area not affected by chromatic aberration.

FIG. 18 illustrates a relationship between a tilt of a specimen and chromatic aberration. FIG. 18 illustrates electron diffraction patterns acquired when the tilt of the crystal zone axis with respect to the optical axis is 0 mrad (without tilt), when the tilt of the crystal zone axis is 13 mrad, when the tilt of the crystal zone axis is 32 mrad, and when the tilt of the crystal zone axis is 65 mrad, and a STEM image of a silicon single crystal photographed from the <110> direction. In the example illustrated in FIG. 18, the area in which the intensity of the Ronchigram is uniform extends to a convergence semi-angle of 80 mrad, and the convergence semi-angle of the condenser aperture 13 is 26.1 mrad.

In the example illustrated in FIG. 18, the shadow of the condenser aperture 13 up to 55.9 mrad (82 mrad - 26.1 mrad) is an area where the intensity of the Ronchigram is uniform even if the crystal zone axis is tilted and, conceivably, there is no aberration effect. However, as illustrated in FIG. 18, chipped electron diffraction spots were observed in one direction depending on the magnitude of the tilt of the crystal zone axis. This is due to the tilt of the electron beam and the effect of chromatic aberration.

In this case, the effect of chromatic aberration depends on the magnitude of the tilt of the electron beam. Therefore, in the electron diffraction pattern illustrated in FIG. 18, chips in the electron diffraction spots become bigger as the tilt of the electron beam increases. In addition, in the STEM image illustrated in FIG. 18, as the tilt of the electron beam increases, a dumbbell structure when the electron beam is incident on the silicon single crystal from the < 110> direction becomes unclear. The magnitude of the tilt of the electron beam for obtaining a good-quality STEM image without the effect of the chromatic aberration is conceivably about 30 mrad.

Therefore, whether or not the tilt of the crystal zone axis is within a valid range is determined according to whether or not the circle created by the shadow of the condenser aperture 13 is positioned within a convergence semi-angle of 30 mrad. Accordingly, an electron beam in an angular range with no chromatic aberration can be selected by the condenser aperture 13 and the specimen S can be illuminated with the electron beam in an angular range with no chromatic aberration.

It should be noted that the embodiments and the modifications described above are merely examples and the invention is not limited thereto. For example, the respective embodiments and the respective modifications may be combined as deemed appropriate.

The invention is not limited to the above-described embodiments, and various modifications can be made. For example, the invention includes configurations that are substantially the same as the configurations described in the embodiments. Substantially same configurations mean configurations having the same functions and methods as those of the configurations described in the embodiments, for example. The invention also includes configurations obtained by replacing non-essential elements of the configurations described in the embodiments with other elements. The invention further includes configurations obtained by adding known art to the configurations described in the embodiments.

## Claims

1. An image acquisition method of acquiring an image of a crystalline specimen in a scanning transmission electron microscope that includes:
an electron source that emits an electron beam;
an illumination system including a condenser lens, an aperture, and an illumination system deflector that deflects the electron beam having passed through the aperture;
a specimen stage that supports a specimen;
an imaging apparatus capable of photographing a Ronchigram formed on a diffraction plane; and
an imaging system deflector that deflects the electron beam to be incident on the imaging apparatus,
the image acquisition method comprising steps of:
aligning a center of the Ronchigram with a center of a detector plane of the imaging apparatus;
aligning a direction of incidence of the electron beam with respect to the specimen with a crystal zone axis of the specimen by aligning a shadow of the aperture with the crystal zone axis on the diffraction plane; and
causing the imaging system deflector to deflect the electron beam to align the electron beam with the center of the detector plane of the imaging apparatus.

2. The image acquisition method according to claim 1, comprising steps of:
determining, after the step of aligning the direction of incidence of the electron beam with the crystal zone axis, whether or not a magnitude of a tilt of the crystal zone axis with respect to an optical axis of the illumination system is within a predetermined range; and
when the magnitude of the tilt of the crystal zone axis has been determined to be outside the predetermined range, tilting the specimen with the specimen stage to reduce the tilt of the crystal zone axis with respect to the optical axis of the illumination system.

3. The image acquisition method according to claim 1 or 2, wherein
in the step of aligning the direction of incidence of the electron beam with the crystal zone axis, the shadow of the aperture is aligned with the crystal zone axis by causing the illumination system deflector to tilt the electron beam.

4. The image acquisition method according to claim 1 or 2, wherein
in the step of aligning the direction of incidence of the electron beam with the crystal zone axis, the shadow of the aperture is aligned with the crystal zone axis by moving the aperture.

5. The image acquisition method according to any one of claims 1 to 4, wherein
in the step of aligning the center of the Ronchigram with the center of the detector plane of the imaging apparatus,
an image of a change in the Ronchigram due to a change in a relative positional relationship between the specimen and the electron beam is acquired, and
the center of the Ronchigram is determined based on the image of the change in the Ronchigram.

6. The image acquisition method according to any one of claims 1 to 5, comprising a step of:
scanning the specimen with the electron beam to acquire a scanned image, wherein
in the step of acquiring the scanned image, a direction in which scan lines are drawn is made orthogonal to a direction of a tilt of the specimen.

7. The image acquisition method according to claim 6, wherein
in the step of acquiring the scanned image, focus is changed by an amount corresponding to the tilt of the specimen every time each of the scan lines is drawn.

8. The image acquisition method according to claim 6, wherein
in the step of acquiring the scanned image, a width of a scan area in a direction of the tilt of the specimen is determined based on the direction of the tilt of the specimen and a magnitude of the tilt of the specimen.

9. The image acquisition method according to claim 6, comprising a step of:
correcting a magnitude of the scanned image in a direction corresponding to the direction of the tilt of the specimen based on the direction of the tilt of the specimen and a magnitude of the tilt of the specimen.

10. The image acquisition method according to claim 6, comprising a step of:
calculating the direction of the tilt of the specimen and a magnitude of the tilt of the specimen based on a deflection direction and a deflection amount of the electron beam by the illumination system deflector.

11. A scanning transmission electron microscope comprising:
an electron source that emits an electron beam;
an illumination system including a condenser lens, an aperture, and an illumination system deflector that deflects the electron beam having passed through the aperture;
a specimen stage that supports a specimen;
an imaging apparatus capable of photographing a Ronchigram formed on a diffraction plane;
an imaging system deflector that deflects the electron beam to be incident on the imaging apparatus; and
a control unit that controls the illumination system and the imaging system deflector,
the control unit performing processing of:
causing the imaging system deflector to deflect the electron beam to align a center of the Ronchigram with a center of a detector plane of the imaging apparatus;
aligning a direction of incidence of the electron beam with respect to the specimen with a crystal zone axis of the specimen by aligning a shadow of the aperture with the crystal zone axis on the diffraction plane; and
causing the imaging system deflector to deflect the electron beam to align the electron beam with the center of the detector plane of the imaging apparatus.

12. The scanning transmission electron microscope according to claim 11, wherein
the control unit performs processing of:
determining, after the processing of aligning the direction of incidence of the electron beam with the crystal zone axis, whether or not a magnitude of a tilt of the crystal zone axis with respect to an optical axis of the illumination system is within a predetermined range; and
when the magnitude of the tilt of the crystal zone axis has been determined to be outside the predetermined range, tilting the specimen with the specimen stage to reduce the tilt of the crystal zone axis with respect to the optical axis of the illumination system.

13. The scanning transmission electron microscope according to claim 11 or 12, wherein
in the processing of aligning the direction of incidence of the electron beam with the crystal zone axis, the control unit aligns the shadow of the aperture with the crystal zone axis by causing the illumination system deflector to tilt the electron beam.

14. The scanning transmission electron microscope according to any one of claims 11 to 13, wherein
in the processing of aligning the center of the Ronchigram with the center of the detector plane of the imaging apparatus, the control unit:
acquires an image of a change in the Ronchigram due to a change in a relative positional relationship between the specimen and the electron beam; and
determines the center of the Ronchigram based on the image of the change in the Ronchigram.

15. The scanning transmission electron microscope according to any one of claims 11 to 14, wherein
the control unit performs processing of scanning the specimen with the electron beam to acquire a scanned image, and
in the processing of acquiring the scanned image, the control unit makes a direction in which scan lines are drawn orthogonal to a direction of a tilt of the specimen.

16. The scanning transmission electron microscope according to claim 15, wherein
in the processing of acquiring the scanned image, the control unit changes focus by an amount corresponding to the tilt of the specimen every time each of the scan lines is drawn.

17. The scanning transmission electron microscope according to claim 15, wherein
in the processing of acquiring the scanned image, the control unit determines a width of a scan area in a direction of the tilt of the specimen based on the direction of the tilt of the specimen and a magnitude of the tilt of the specimen.

18. A scanning transmission electron microscope comprising:
an electron source that emits an electron beam;
an illumination system for scanning a specimen with the electron beam;
a specimen stage that supports the specimen;
a detector that detects electrons having passed through the specimen; and
a control unit that controls the illumination system,
the control unit performing processing of scanning the specimen with the electron beam to acquire a scanned image, and
in the processing of acquiring the scanned image, the control unit makes a direction in which scan lines are drawn orthogonal to a direction of a tilt of the specimen.
